(19) **Europäisches Patentamt**
**European Patent Office**
**Office européen des brevets**

(11) **EP 1 356 586 B1**

(12) **EUROPEAN PATENT SPECIFICATION**

(45) Date of publication and mention
of the grant of the patent:
**30.07.2008   Bulletin 2008/31**

(51) Int Cl.:
*H03G 1/00* (2006.01)

(21) Application number: **01999039.9**

(86) International application number:
**PCT/EP2001/014221**

(22) Date of filing: **30.11.2001**

(87) International publication number:
**WO 2002/045258 (06.06.2002 Gazette 2002/23)**

(54) **METHOD OF LINEARISING A SIGNAL**

VERFAHREN ZUR SIGNALLINEARISIERUNG

PROCEDE DE LINEARISATION D'UN SIGNAL

(84) Designated Contracting States:
**DE FR IT**

(30) Priority: **02.12.2000   GB 0029420**

(43) Date of publication of application:
**29.10.2003   Bulletin 2003/44**

(73) Proprietor: **Nokia Siemens Networks GmbH & Co. KG**
**81541 München (DE)**

(72) Inventors:
• **DEMAIN, P.**
**Romsey, Hampshire SO51 5BP (GB)**
• **TONER, B.**
**Romsey,**
**Hampshire SO51 0PU (GB)**
• **DOMOKOS, J.**
**Fordingbridge, Hampshire (GB)**

(74) Representative: **Ruuskanen, Juha-Pekka et al**
**Page White & Farrer**
**Bedford House**
**John Street**
**London, WC1N  2BF (GB)**

(56) References cited:
WO-A-92/08297          US-A- 5 923 712
US-A- 6 141 390

• YU T ET AL: "Application of nurbs in numerical grid generation" COMPUTER AIDED DESIGN, ELSEVIER PUBLISHERS BV., BARKING, GB, vol. 27, no. 2, 1 February 1995 (1995-02-01), pages 147-157, XP004022836 ISSN: 0010-4485
• STAPLETON S P ET AL: "SIMULATION AND ANALYSIS OF AN ADAPTIVE PREDISTORTER UTILIZING A COMPLEX SPECTRAL CONVOLUTION" IEEE TRANSACTIONS ON VEHICULAR TECHNOLOGY, IEEE INC. NEW YORK, US, vol. 41, no. 4, 1 November 1992 (1992-11-01), pages 387-394, XP000362352 ISSN: 0018-9545

## Description

The invention relates to a method of linearising a non-linear device and has particular but not exclusive application to linearsed power amplifiers. The invention also relates to linearised power amplifiers embodying the method. It should be noted however, that the invention can be embodied in any system which has a non linear characteristic.

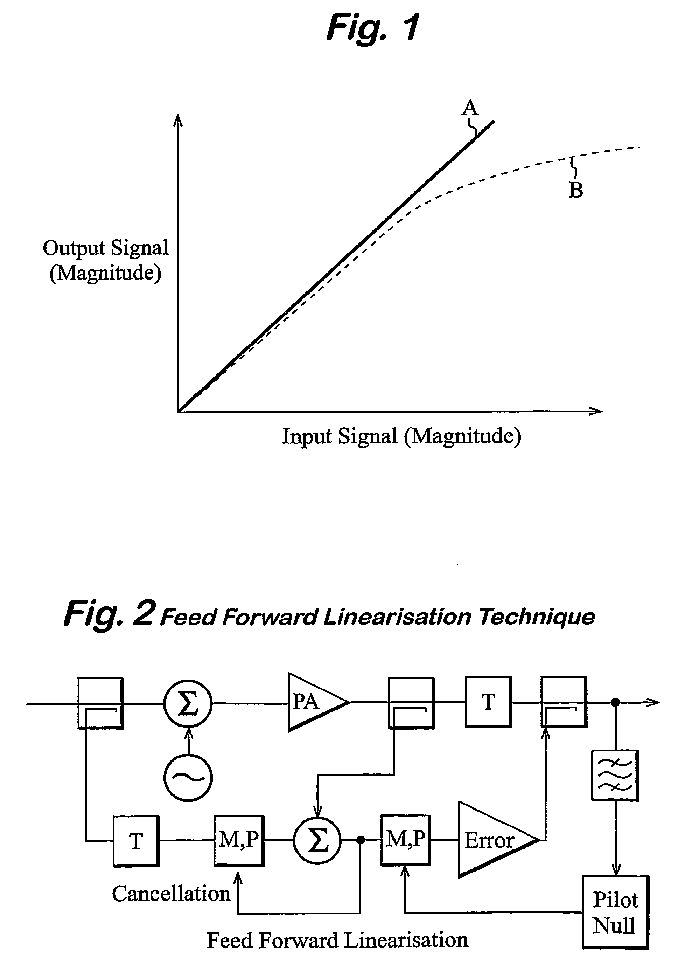

Figure 1 shows a schematic graph illustrating the characteristic of a non linear system or component such as a power amplifier. The X-axis represents nominally the magnitude of the input to the power amplifier at a particular instant and resultant magnitude of the output is shown on the Y-axis. An ideal linear system is **characterised** by the complete line A. However, in practice, the real characteristics of an amplifier are likely to be non-linear as represented by the broken or dashed line B. As can be seen saturation occurs at high magnitudes of input such that increasing input does not result in a corresponding increase in the output signal.

Known linearisation techniques applied to power amplifiers essentially consist of three parts: a non-linear device i.e. an RF amplifier; an output signal measurement subsystem; and a linearisation subsystem i.e. feed forward or predistortion. In order to appreciate the invention prior art linearisation methods are briefly described.

One solution to the linearisation is by means of so called feed forward linearisation which is illustrated schematically in figure 2. Such an implementation includes a cancellation loop, feed forward loop and a measurement subsystem; the latter being essentially a selective pilot receiver measuring the power spectral density (PSD) of the residual tone at the output. The key aspect of this method is that the PSD is measured and hence large dynamic range is achieved. The measurement subsystem is based on pilot signal and not on a graphical method. This solution achieves a very high linearity and excellent signal to noise ratios in excess of 70 dB. The disadvantage of the pilot is that there is poor correlation between the minima and linearity and ACPR (Adjacent Channel Power Ratio). This can be improved by a spread pilot scheme but this is complex. Another disadvantage of feed forward technique is the poor efficiency due to coupler delay line losses and the need for an error amplifier.

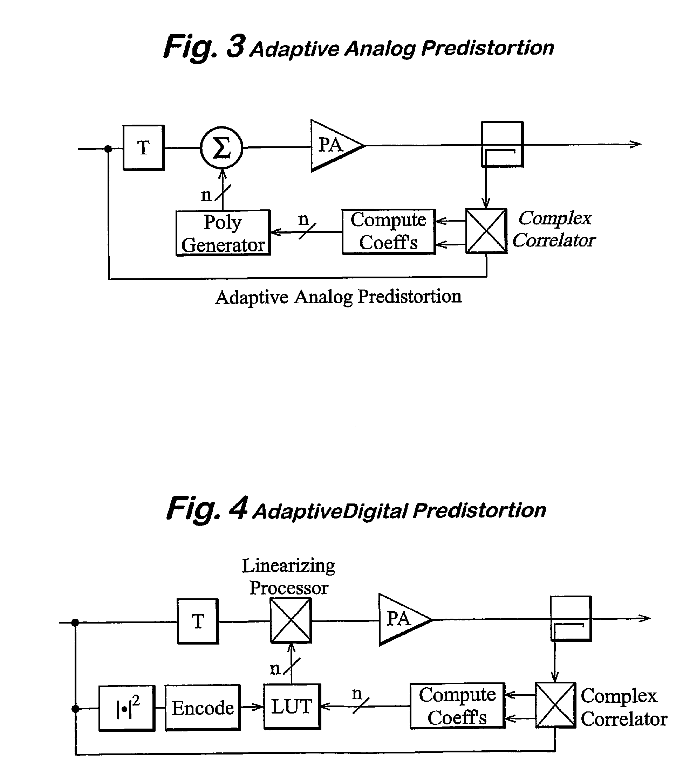

Another method of providing linearisation is that of adaptive analogue predistortion. Figure 3 shows a schematic representation of an adaptive analogue predistortion system. This shows power amplifier 1 the output of which is additionally input into a complex demodulator whereafter coefficients of a polynomial, representative of the inverse characteristic of the power amplifier, are computed. This polynomial is generated and applied to the signal which is input into the power amplifier. In this way the input signal is modified such that attenuated parts of the output signal are amplified and phase adjusted to compensate for the non-linear effects; the input signal to the power amplifier is predistorted. There are however, three problems associated with such predistortion. This system necessitates the use of a complex down-converter. The complex down sampler has less dynamic range than that of the PSD measurement receiver because the full signal bandwidth has to be digitised instantaneously. This is an issue particularly for W-CDMA (Wideband Code Division Multiple Access) application which has higher bandwidth than an EDGE carrier. Also because the polynomial generator comprises analogue circuitry it is inherently imperfect especially for high order terms because of delay mismatch, linearity, etc. This is limiting the bandwidth and the quality of curve fit hence the linearity also. It has also been found that polynomial generation does not achieve good fit always and in some cases may become unstable and produce ripple effects through the various sections of the characteristics.

Digital pre-distortion is also known. In prior art digital predistortion systems again a complex down-converter is required in the measurement subsystem. This restricts the dynamic range, especially for broadband systems. Figure 4 shows a schematic block diagram of a known digital predistortion system. In such prior art systems spline and rational polynomials are used for linearising the amplifier. The nature of pre-distortion demands a method of applying inverse transfer function characteristics to the amplifier source data. The pre-distortion has been applied in this method by means of determining the coefficients of a polynomial representing the inverse characteristic, and points on the curve are stored in Look-Up Tables (LUT) generator. However there are problems with achieving stable polynomials that correctly characterise a typical amplifier inverse transfer characteristic.

There is not always a deterministic relationship between PSD and the characteristics of the non-linear device. Therefore the optimum pre-distortion, which is the inverse of the non-linear characteristics, cannot always be readily calculated.

US5923712 describes a system for linearly transmitting an amplified output signal using predistortion by amplifying an inverse characteristic from a look up table.

US6141390 relates to a system for linearly transmitting an amplified output signal using predistortion. The system uses a straight inverse modelling scheme with orthogonal predictor variables and indexes a look up table using modulated input signals.

WO92/08297 describes linearising the gain of a non-linear power amplifier in a TDM transceiver. An inverse transfer function is determined and a correlation value applied to the input signal.

It is an object of the invention to provide a method of accurately describing typical amplifier characteristics for any system whilst maintaining stability and practical implementation ability. It is further an object of the current invention to overcome the above mentioned problems and to provide a linearisation system which is fast and effective.

In accordance with a first aspect of the present invention a method of linearising the output signal of a component having an input signal comprises a) taking an initial estimated representation of the component inverse transfer characteristics; b) manipulating said representation; c) pre-distorting said input signal by applying values of said representation to the input signal; d) determining the error in terms of linearity between the input signal and the output signal; and e) repeating steps b) to d) such that the error is minimised; wherein the inverse transfer characteristic is represented as a series of basis functions in a NURBS curve representation; and said manipulation comprises scaling of the individual basis functions.

Additionally the above method is useable with PSD measurement alone and advantageously does not require phase information. If the lineariser is capable of operating without the phase information of the signal, much larger bandwidth and larger signal to noise ratio can be achieved with the measurement receiver.

The optimum pre-distortion characteristics may be determined by a predefined search method. The iteration is carried out graphically using NURBS (Non - Uniform Rational B-Splines). In most cases, a single error value is required for the curve fit, which represents the overall spectral regrowth due to the residual non-linearity.

Preferably the area between the target power spectral density and the measured power spectral density is minimised across the full range of the spectrum. In a preferred embodiment the iteration is done so as to minimise the error at particular regions of the spectra. Such a weighting of the different regions of the spectra is also found to play a major role in the stability and the convergence of the loop.

In accordance with a second aspect of the present invention, a system to linearise the output signal of a component having an input signal comprises a) means to take an initial estimated representation of a component inverse transfer characteristic; b) means to manipulate said representation; c) means to pre-distort said input signal by applying values of said representation to the input signal; d) means to determine the error in terms of linearity between the input signal and the output signal; and e) means to repeat steps b) to d) such that the error is minimised; wherein the inverse transfer characteristic is represented as a series of basis functions in a NURBS curve representation; and said manipulation means comprises means to scale the individual basis functions.

Other advantages of the invention and its various embodiments are : the error value to represent the whole spectra with appropriate weighting for best convergence and stability; the best possible noise immunity without compromising the spectral resolution is achieved, it is ensured that global minima is achieved without random search, and provide a single error value for the linearisation loop from PSD measurement of the output signal and ensure convergence to best Error Vector Magnitude

The invention will now be described by way of example only and with reference to the additional following figures of which:

Figure 5 shows a block diagram representing an embodiment of the invention.

Figure 6 shows a preferred method of determining the linearisation error between the input and output signals.

Figure 7 show an example of how the inverse transfer function curve may be represented and manipulated.

Figure 8a and b shows an alternative method of the representation of the inverse transfer function curve.

Figure 9 shows a flow diagram showing a preferred method of determining the error.

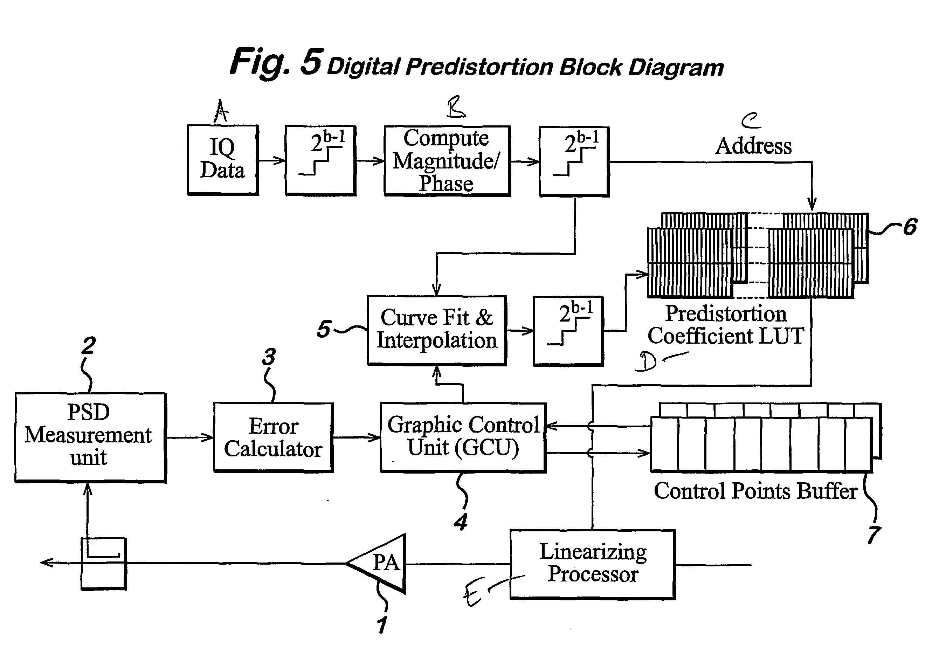

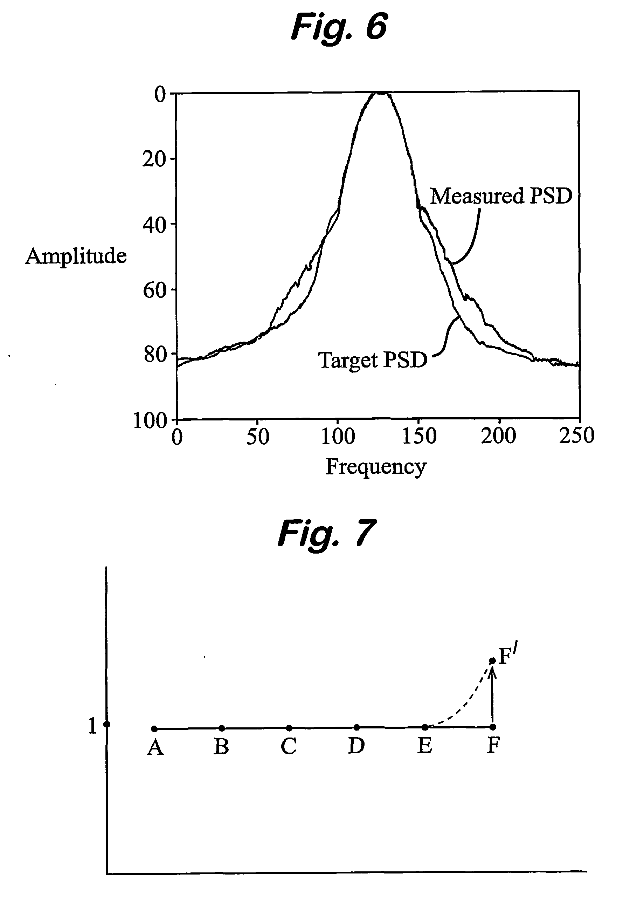

Figure 5 shows a schematic block diagram of the system according to one embodiment of the invention and comprises the Power Amplifier 1. The signal from the power amplifier is fed into a Power Spectral Density measurement unit 2. This unit measures the power spectral density of the signal; figure 6 shows a representation of a target spectrum and a measured spectrum. Measured PSD, MPSD, is measured at the output of the power amplifier and includes pre-distortion and Target PSD, TPSD, is how the measured PSD should be once pre-distortion is optimized.

The advantage of using power spectral density as a measure of the signal is that it is done in the frequency domain and is a relatively simple process. Data relating to PSD is input to an Error Calculator 3, which calculates the difference between the measured spectrum and a target spectrum which has been pre-computed and stored in look-up format.

The result is then input into a Graphic Control Unit 4 whose operation is at the heart of the invention. The Graphic Control Units function is to determine the fundamentals of the inverse transfer function (curve) which should be applied eventually to the input signal to minimise the distortion. The output of the GCU is to a curve fit and interpolation unit 5, which essentially computes and interpolates the basic characteristics of the distortion inverse curve, so as to provide a whole series of point values which are stored in the pre-distortion coefficient Look-Up Tables (LUT) 6 at the resolution of the signal to be predistorted. (The term "coefficient" here represents high resolution coefficients which are interpolated from the representation, which may be a series of just a few points, and is not to be confused with the term coefficients of a polynomial representing the inverse transfer function as in prior art systems). These pre-distortion coefficients are then fed back to a linearising processor which essentially uses the appropriate data from Look-Up Table to modify the input signal to the Power Amplifier. The LUT contains the pre-distortion coefficients for all possible input values at a given bit resolution and are addressed using the baseband input value signals.

The essence of the invention is that the inverse transfer function i.e. the pre-distortion which is to be applied to the input signal is represented as look up tables as in the prior art, but that rather than it being provided by calculating a series of coefficients of a polynomial, it is represented by a series of control points, stored in buffer 7. (alternatively described as "handles"), i.e. a curve through the control points or generated from NURBS (see later) which can be manipulated.

The operation of the graphic control unit and manipulation of the control points will now be described in more detail. The graphical control unit begins to move each control point of the complex transfer characteristics, following a predefined methodology, and feedback from the error calculator enables the graphic control unit to decide whether the control point or handle has been moved in the right direction.

**Example 1**

Figure 7 shows an initial set up of control points, A to E representing the inverse transfer characteristics (or inverse curve) In this example all the control points are set to 1, and thus the "curve" or characteristic is a straight line. When these characteristics are stored as pre-distortion coefficients, the curve fit and interpolation unit would store all the values in the look up tables as 1. When applied to the input signal it would leave the input signal unchanged.

In next stage the last of the control points F is slid vertically up the y axis by a fixed amount to new position F'. The coefficients representing a curve passing through the control points i.e. representing the complex pre-distortion function are then recalculated and fed into the look up tables.

The linear processor applies these to the input signal to the power amplifier and then the error calculation is once again made. Should the error increase then generally speaking the control point has been moved in the wrong direction. The control points are then moved (or "slid") in turn in a predetermined order and between each movement the inverse transfer function (pre-distortion curve) characteristics are re-interpolated to the resolution stored in the look-up tables. Again when applied to the power amplifier the feedback determines the error and a better position for the handle is calculated. This process is therefore iterative and eventually the optimum position of the control points representing a distortion curve is determined so as to minimise the error.

The skilled person would realise that there are an infinite number of ways in which the control points may be manipulated. They could be manipulated sequentially in ascending or descending order or indeed more than one control point may me moved at the same time. Various mathematical techniques may additionally be employed to ensure that the optimum position of control points i.e. which is the optimum pre-distortion curve.

The term making an "initial estimated representation", as in the main claim includes

a) making some estimates of how much error is on the signal and subsequently fit an inverse compression curve to this data, and
b) simply initialising the control point buffers and coefficient LUTs to all a set value e.g. ones (i.e. no predistortion is applied)

However the inventors have determined that the first method of estimating the initial distortion levels is prone to bias and the accuracy of the estimate is not particularly consistent. The other option of starting the algorithm with no predistortion produces a more consistent result, and furthermore it is not necessarily any slower to converge the PSD error function to a minimum

**Example 2**

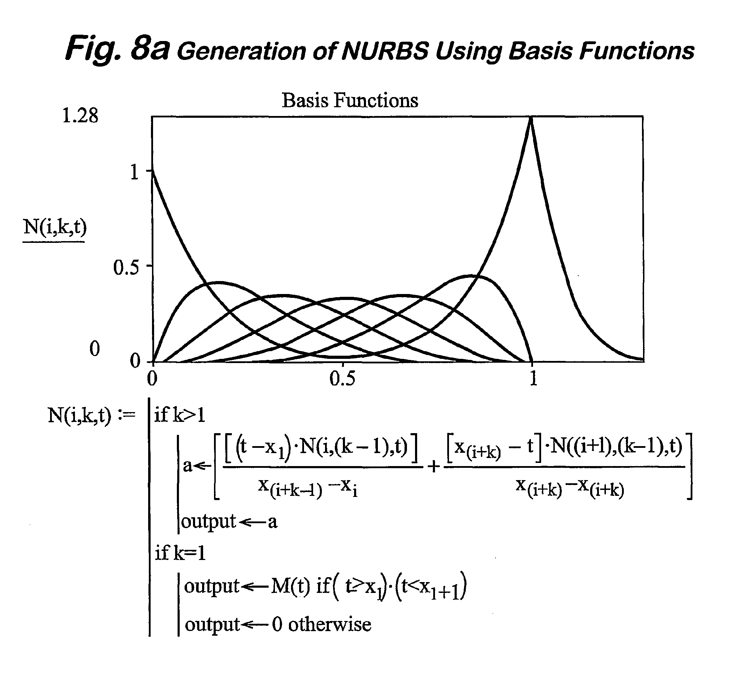

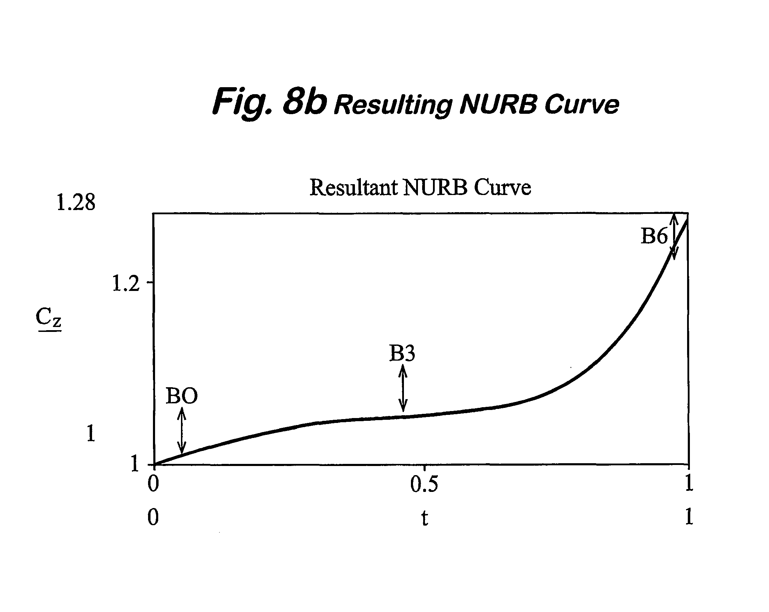

The inventors have additionally determined that the invention can be further improved by representation of the inverse curve, i.e. the inverse transfer characteristic, as a series of basis functions; which can be advantageously manipulated before summing to produce a NURBS curve are particularly effective at implementing the above mentioned embodiment. Figure 8a shows a series of basis functions and figure 8b shows the interpolated transfer function they represent. The transfer function simply comprises the superposition of a number, seven in this example, of individual basis functions, A to G.

Each individual basis function can be manipulated in turn by scaling, and after each scaling, the error between the target and measured power spectral densities can be measured. Effectively the individual basis functions are weighted.

In view of the substantial advantages of NURBS modeling seen, this technique's flexibility enables its use in other linearisation contexts. The number of weights correspond to the number of basis functions and the number of basis functions correspond to the order of the curve. The basis functions are generated recursively to fit any arbitrary curve description and are evaluated at the desired interpolation resolution. Once the basis functions have been calculated, real time shaping of the curve to fit any other arbitrary curve is performed by simply adjusting the weights of each basis function and summing them in a predefined fashion. The nature of the simplistic and fast adjustment of curve shape makes this method of curve generation ideal for representing amplifier inverse transfer functions in digital hardware.

The advantages of a NURBS curve compared to a polynomial curve are the following:

a) independently definable regions of the curve; the summation of the basis functions at any point on the x-axis will result in the corresponding y-axis value. As the basis functions only have a finite range within the overall curve range, regions of the curve can be adjusted independently without undesirable effects on other regions.

b) the stability of the system is inherent, due to the independently definable regions of the curve. When an adjustment needs to be made to one region of the curve (e.g. the compression is to be hardened) it can be assured that other regions of the curve will not be affected by ripples caused by the change. This, of course, could not be guaranteed with a polynomial as certain curve shapes may fall out of the boundary of that particular order of polynomial, thus creating a ripple effect throughout the curve.

c) the accuracy to fit to amplifier characteristics; the variation of the weight of one basis function will only affect the overall curve within the region of that particular basis function thus providing the ability for a curve to show predominately 7$^{th}$ order characteristics in one half of the curve whilst remaining linear in the other half, which would not be achievable with a single polynomial. This effect is particularly useful when characterising an amplifier with a very good linearity at low signal values and high order compression at larger signal values.

d) reduced real time computation complexity; since the computation of the curve points is carried out by summing each weighted pre-computed basis function at a particular x value, the basis functions for a particular system can be recursively calculated offline and stored in look-up tables. Real time computation then only requires each basis function to be read at a particular point, weighted, and summed.

In a preferred embodiment of the invention the inventors have determined a preferred way of generating the error which is to be minimised; it is a graphical method for providing error feedback for adaptive linearisation. The error is calculated by comparing the measured PSD point by point with a pre-calculated desirable spectral contours. The error is the total area, by which the contours are exceeded, therefore,

$$E = \sum_{i=l}^{l} PSD(i) - T\arg et(i)$$

*PSD* and *Target* are the normalized spectra points in dB and *1* is the length of the spectra vector given that the error is integrated over the entire span of the PSD, 1, maximum noise immunity is achieved. A set of spectral contours is generated representing the desirable profiles through the linearisation process. The first contour in the set corresponds to the spectra resulting from the original non-linear characteristics of the typical device. The last contour in the set, the target contour, corresponds to the ideal (target) spectra. The intermediate contours in the set provide a desirable path, through which the spectral optimisation should progress. The various spectral contours are chosen so, that the both the EVM and the PSD improves progressively as the spectral optimisation is progressing and local minimums are avoided. At this stage it is too early to specify these contours, but it is envisaged that after extensive characterisation an optimum contour set can be built.

The stability and the convergence speed of the linearisation loop are critical parameters. Hence, it is crucial that the noise is suppressed as far as possible. Furthermore, error in the PSD relationship may contain several local minima. Random search must not be used to jump through these locations because it would lead to gross mask violations.

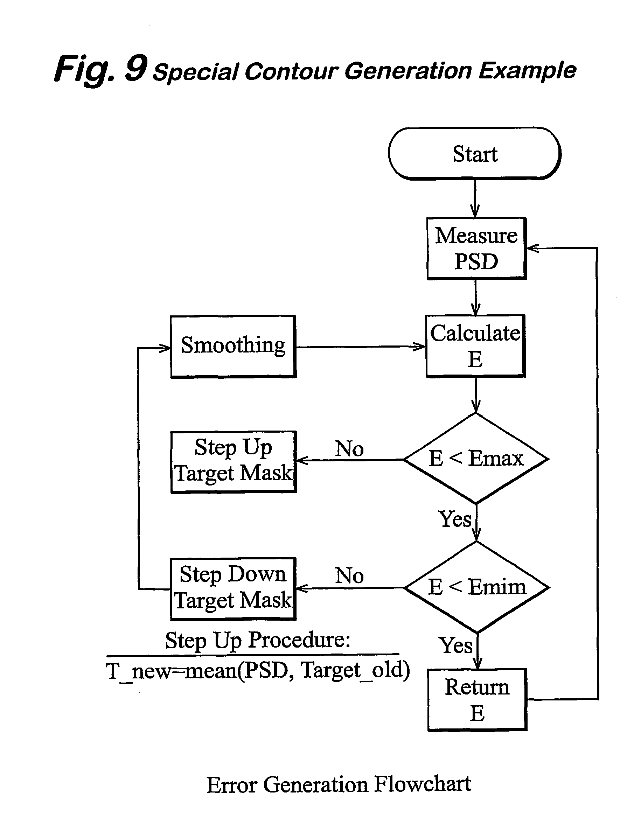

The spacing of the intermediate masks should be close enough to produce a sharp error function between the measured PSD and the current contour thus steering towards the global minima. Initially the PSD is compared with the first (i.e. the worst spectra) contour and the error is minimised within the iterative lineariser. As soon as the error becomes zero, the iteration continues with the second contour within the set. The process eventually reaches the target contour, which is then continuously held. One possible method for building intermediate spectra contours is illustrated by the following flowchart of figure 9.

**Claims**

1. A method of linearising the output signal of a component having an input signal, the method comprising;

a) taking (B) an initial estimated representation of the component inverse transfer characteristic;
b) manipulating (5) said representation;
c) pre-distorting (D) said input signal by applying values of said representation to the input signal;
d) determining (3) the error in terms of linearity between the input signal and the output signal; and
e) repeating steps b) to d) such that the error is minimized;

**characterised in that,** the inverse transfer characteristic is represented as a series of basis functions in a NURBS (Non-Uniform Rational B-Splines) curve representation; and said manipulation comprises scaling of the individual basis functions.

**2.** A method as claimed in claim 1, wherein step d) comprises determining (3) the error between the measured power spectral density and the target spectral density.

**3.** A method as claimed in claim 2 wherein step d) minimises the area between the target power spectral density and the measured power spectral density (2) across the full range of the spectrum

**4.** A method as claimed in claim 2 wherein step d) minimised the error between target power spectral density and the measured power spectral density (2) within a specific region of the power spectrum.

**5.** A method as claimed in any preceding claim, wherein step a) assumes no pre-distortion.

**6.** A method as claimed in any preceding claim, wherein said component is an amplifier.

**7.** A system to linearise the output signal of a component having an input signal, the system comprising:

a) means (B) to take an initial estimated representation of a component inverse transfer characteristic;
b) means (5) to manipulate said representation;
c) means (6) to pre-distort said input signal by applying values of said representation to the input signal;
d) means (3) to determine the error in terms of linearity between the input signal and the output signal; and
e) means to repeat steps b) to d) such that the error is minimised;

**characterised in that** the inverse transfer characteristic is represented as a series of basis functions in a NURBS (Non-Uniform Rational B-Splines) curve representation; and said manipulation means comprises means to scale the individual basis functions.

**8.** A system as claimed in claim 7, wherein said means (3) to determine error comprises means to determine the error between the measured power spectral density (2) and the target spectral density.

**9.** A system as claimed in claims 7 or claim 8, wherein said component is an amplifier.

**Patentansprüche**

**1.** Verfahren zum Linearisieren des Ausgangssignals einer Komponente mit einem Eingangssignal, wobei das Verfahren umfasst:

- Nehmen (B) einer anfänglich abgeschätzten Darstellung eines inversen Transfermerkmals einer Komponente;
- Verändern (5) der Darstellung;
- Vor-Verzerren (D) des Eingangssignals durch Anwenden von Werten der Darstellung auf das Eingangssignal;
- Bestimmen (3) des Fehlers in Hinblick auf Linearität zwischen dem Eingangssignal und dem Ausgangssignal; und
- Wiederholen der Schritte b) bis d), sodass der Fehler minimiert wird; **dadurch gekennzeichnet, dass** das inverse Transfermerkmal als Reihe von Basisfunktionen in einer NURBS (Non-Uniform Rational B-Splines)-Kurvendarstellung dargestellt wird; und das Verändern das Skalieren der individuellen Basisfunktion umfasst.

**2.** Verfahren nach Anspruch 1, wobei Schritt d) ein Bestimmen (3) des Fehlers zwischen der erfassten Leistungs-Spektral-Dichte und der Ziel-Spektral-Dichte umfasst.

**3.** Verfahren nach Anspruch 2, wobei Schritt d) das Gebiet zwischen der Ziel-Spektral-Dichte und der erfassten Leistungs-Spektral-Dichte (2) über den gesamten Bereich des Spektrums minimiert.

**4.** Verfahren nach Anspruch 2, wobei Schritt d) den Fehler zwischen der Ziel-Spektral-Dichte und der erfassten Leistungs-Spektral-Dichte (2) innerhalb eines spezifischen Bereichs des Leistungsspektrums minimiert.

**5.** Verfahren nach einem der vorhergehenden Ansprüche, wobei Schritt a) nicht von einem Vor-Verzerren ausgeht.

**6.** Verfahren nach einem der vorhergehenden Ansprüche, wobei die Komponente ein Verstärker ist.

**7.** System zum Linearisieren des Ausgangssignals einer Komponente mit einem Eingangssignal, wobei das System umfasst:

- Mittel (B) zum Nehmen einer anfänglich abgeschätzten Darstellung eines inversen Transfermerkmals einer Komponente;
- Mittel (5) zum Verändern der Darstellung;
- Mittel (6) zum Vor-Verzerren des Eingangsignals durch Anwenden von Werten der Darstellung auf das Eingangssignal;
- Mittel (3) zum Bestimmen des Fehlers in Hinblick auf Linearität zwischen dem Eingangssignal und dem Ausgangssignal; und
- Mittel zum Wiederholen der Schritte b) bis d), sodass der Fehler minimiert wird; **dadurch gekennzeichnet, dass** das inverse Transfermerkmal als Reihe von Basisfunktionen in einer NURBS (Non-Uniform Rational B-Splines)-Kurvendarstellung dargestellt wird; und das Veränderungs-Mittel Skalieren-Mittel der individuellen Basisfunktion umfasst.

**8.** System nach Anspruch 7, wobei das Mittel (3) zum Bestimmen eines Fehlers Mittel zum Bestimmen des Fehlers zwischen der erfassten Leistungs-Spektral-Dichte (2) und der Ziel-Spektral-Dichte umfasst.

**9.** System nach Anspruch 7 oder 8, wobei die Komponente ein Verstärker ist.

## Revendications

**1.** Procédé de linéarisation du signal de sortie d'un composant ayant un signal d'entrée, le procédé comprenant les étapes consistant à :

a) prendre (B) une représentation estimée initiale de la caractéristique de transfert inverse du composant ;
b) manipuler (5) ladite représentation ;
c) pré-distordre (D) ledit signal d'entrée en appliquant des valeurs de ladite représentation au signal d'entrée ;
d) déterminer (3) l'erreur en termes de linéarité entre le signal d'entrée et le signal de sortie ; et
e) répéter les étapes b) à d) de sorte que l'erreur soit minimisée ; **caractérisé en ce que** la caractéristique de transfert inverse est représentée sous forme d'une série de fonctions de base dans une représentation de courbe NURBS (Non-Uniform Rational B-Splines - B-splines rationnelles non uniformes) **en ce que** ladite manipulation comprend la mise à l'échelle des fonctions de base individuelles.

**2.** Procédé selon la revendication 1, dans lequel l'étape d) comprend l'étape consistant à déterminer (3) l'erreur entre la densité spectrale de puissance mesurée et la densité spectrale cible.

**3.** Procédé selon la revendication 2, dans lequel l'étape d) minimise la zone entre la densité spectrale de puissance cible et la densité spectrale de puissance mesurée (2) sur toute la plage du spectre.

**4.** Procédé selon la revendication 2, dans lequel l'étape d) comprend l'étape consistant à minimiser l'erreur entre la densité spectrale de puissance cible et la densité spectrale de puissance mesurée (2) à l'intérieur d'une région spécifique du spectre de puissance.

**5.** Procédé selon l'une quelconque des revendications précédentes, dans lequel l'étape a) suppose l'absence de pré-distorsion.

**6.** Procédé selon l'une quelconque des revendications précédentes, dans lequel ledit composant est un amplificateur.

**7.** Système pour linéariser le signal de sortie du composant ayant un signal d'entrée, le système comprenant :

a) des moyens (B) pour prendre une représentation estimée initiale d'une caractéristique de transfert inverse du composant ;
b) des moyens (5) pour manipuler ladite représentation ;
c) des moyens (6) pour pré-distordre ledit signal d'entrée en appliquant des valeurs de ladite représentation au signal d'entrée ;
d) des moyens (3) pour déterminer l'erreur en termes de linéarité entre le signal d'entrée et le signal de sortie ; et
e) des moyens pour répéter les étapes b) à d) de sorte que l'erreur soit minimisée ;

**caractérisé en ce que** la caractéristique de transfert inverse est représentée sous forme d'une série de fonctions de base dans une représentation de courbe NURBS (Non-Uniform Rational B-Splines - B-splines rationnelles non uniformes) **en ce que** lesdits moyens de manipulation comprennent des moyens pour mettre à l'échelle des fonctions de base individuelles.

**8.** Système selon la revendication 7, dans lequel lesdits moyens (3) pour déterminer l'erreur comprennent des moyens pour déterminer l'erreur entre la densité spectrale de puissance mesurée (2) et la densité spectrale cible.

**9.** Système selon la revendication 7 ou 8, dans lequel ledit composant est un amplificateur.

# *Fig. 1*

# *Fig. 2* *Feed Forward Linearisation Technique*

## *Fig. 3* Adaptive Analog Predistortion

Adaptive Analog Predistortion

## *Fig. 4* AdaptiveDigital Predistortion

# Fig. 5 *Digital Predistortion Block Diagram*

## *Fig. 6*

## *Fig. 7*

# *Fig. 8a* Generation of NURBS Using Basis Functions

Basis Functions

$$N(i,k,t) := \begin{array}{|l} \text{if } k>1 \\ \quad \begin{array}{|l} a \leftarrow \left[ \dfrac{\left[ (t-x_1) \cdot N(i,(k-1),t) \right]}{x_{(i+k-1)} - x_i} + \dfrac{\left[ x_{(i+k)} - t \right] \cdot N((i+1),(k-1),t)}{x_{(i+k)} - x_{(i+k)}} \right] \\ \text{output} \leftarrow a \end{array} \\ \text{if } k=1 \\ \quad \begin{array}{|l} \text{output} \leftarrow M(t) \text{ if} \left( t > x_1 \right) \cdot \left( t < x_{1+1} \right) \\ \text{output} \leftarrow 0 \text{ otherwise} \end{array} \end{array}$$

## Fig. 8b Resulting NURB Curve

Resultant NURB Curve

EP 1 356 586 B1

# *Fig. 9* Special Contour Generation Example

```
                                    ⎧  Start  ⎫
                                    ⎩         ⎭
                                        │
                                        ▼
                                  ┌──────────┐
                                  │ Measure  │◄──────────┐
                                  │   PSD    │           │
                                  └──────────┘           │
                                        │                │
                                        ▼                │
    ┌───────────┐              ┌──────────┐              │
    │ Smoothing │─────────────►│ Calculate│              │
    │           │              │    E     │              │
    └───────────┘              └──────────┘              │
         ▲                          │                    │
         │                          ▼                    │
    ┌───────────┐   No      ◄ E < Emax ►                 │
    │  Step Up  │◄──────────                             │
    │Target Mask│                    │ Yes               │
    └───────────┘                    ▼                    │
         │                                                │
         │                                                │
    ┌───────────┐   No      ◄ E < Emim ►                 │
    │ Step Down │◄──────────                             │
    │Target Mask│                    │ Yes               │
    └───────────┘              ┌──────────┐              │
                               │  Return  │──────────────┘
   Step Up Procedure:          │    E     │
   ─────────────────────       └──────────┘
   T_new=mean(PSD, Target_old)
```

Error Generation Flowchart

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5923712 A
- US 6141390 A

- WO 9208297 A